Europäisches Patentamt

European Patent Office

Office européen des brevets

(19)

(11) Veröffentlichungsnummer: **0 211 210 B1**

(12) **EUROPÄISCHE PATENTSCHRIFT**

(45) Veröffentlichungstag der Patentschrift: **25.09.91**

(51) Int. Cl.5: **H03F 3/217**

(21) Anmeldenummer: **86108579.3**

(22) Anmeldetag: **24.06.86**

(54) **Schaltverstärker.**

(30) Priorität: **20.07.85 DE 3526072**
**31.10.85 DE 3538661**

(43) Veröffentlichungstag der Anmeldung:
**25.02.87 Patentblatt 87/09**

(45) Bekanntmachung des Hinweises auf die
Patenterteilung:
**25.09.91 Patentblatt 91/39**

(84) Benannte Vertragsstaaten:
**CH DE FR GB LI**

(56) Entgegenhaltungen:
**GB-A- 1 248 209**
**GB-A- 2 102 230**
**US-A- 3 956 716**
**US-A- 4 573 018**

**PATENTS ABSTRACTS OF JAPAN, Band 1,
Nr. 39, März 1977, Seite 1187 E 76; & JP-A-51
123 546 (TOKYO SHIBAURA DENKI K.K.)
28.10.1976**

**TELECOMMUNICATIONS & RADIO ENGINEE-
RING, Band 31/32, Nr. 3, März 1977, Seiten
134-136, Washington, US; A.A. ALEKSANYAN
et al.: "Low-frequency amplifier using thyristors"**

(73) Patentinhaber: **Licentia Patent-
Verwaltungs-GmbH
Theodor-Stern-Kai 1
W-6000 Frankfurt/Main 70(DE)**

(72) Erfinder: **Beeken, Horst, Dipl.-Ing.
Teltowerstrasse 14
W-1000 Berlin 14(DE)**

(74) Vertreter: **Schulze, Harald Rudolf, Dipl.-Ing.
Licentia Patent-Verwaltungs-GmbH Theodor-
Stern-Kai 1
W-6000 Frankfurt/Main 70(DE)**

**Beschreibung**

Die Erfindung betrifft einen Schaltverstärker nach dem Oberbegriff des Patentanspruchs 1.

Die Erfindung betrifft insbesondere einen Schaltverstärker zur Erzeugung eines verstärkten NF-Signales (Niederfrequenz-Signales) für eine amplitudenmodulierte Anodenspannung eines Hochfrequenz-Hochleistungssenders.

Die britische Patentschrift GB 12 48 209 beschreibt eine Schaltung für die Verstärkung von NF-Signalen in Rundfunksendern. Die Verstärkung der NF-Signale erfolgt in dieser Schaltung mittels einer eingangsseitigen PDM-Modulation (Pulsdauermodulation) des NF-Signales, anschließender Verstärkung der PDM-Pulse in Pulsverstärkern, Ausgangstransformation der verstärkten PDM-Pulse, Gleichrichtung der hochtransformierten PDM-Pulse und einer abschließenden Ausfilterung von höherfrequenten Signalteilen in einem Tiefpaß. Wegen der Leistungsbegrenzung der Pulsverstärker wird das PDM-Signal dabei in zwei Teilsignale aufgeteilt; derart, daß jeweils ein Teilsignal aus jedem zweiten aufeinfolgenden Puls besteht. Bei der Teilung bleibt die Pulsdauer aus der PDM-Modulation für jeden einzelnen Puls erhalten, es verringert sich aber in den Teilsignalen die Taktrate um die Hälfte. Nachteilig ist in dieser Schaltung das Auftreten von Verzerrungen des NF-Signales bei Unterstrich-Betrieb, die auf die dabei zu verstärkenden kurzen PDM-Pulse zurückzuführen sind und die begrenzte Leistung der Pulsverstärker.

Es ist außerdem bekannt einen gleichspannungsgespeisten Brückenumformer als Ausgangsstufe in einem Pulsgenerator einzusetzen (GB 21 02 230 A). Der Brückenumformer besteht aus zwei parallel geschalteten Zweigen mit je zwei hintereinandergeschalteten Halbleiterschaltern. Der Brückenausgang liegt zwischen den Verbindungspunkten der Schalter eines jeden Zweiges und speist die Primärwicklung eines Ausgangstransformators. Die Halbleiterschalter werden abwechselnd so gesteuert, daß jeweils zwei kreuzweise gegenüberliegende Schalter der Brücke geöffnet und die anderen beiden Schalter geschlossen sind. Dadurch wird die Primärwicklung des Ausgangstransformators in wechselnden Richtungen von der an der Brücke liegenden Gleichspannung beaufschlagt. Dem Ausgangstransformator schließt sich eine Vollweggleichrichtung an. Diese Brückenumformer ermöglichen hohe Pulsausgangsleistungen. Die Verwendung eines derartigen Brückenumformers bei der direkte Verstärkung von Pulsen eines PDM-Signales hat ebenfalls den Nachteil, daß das Schalten von kurzen, nadelförmigen PDM-Pulsen zu Verzerrungen des zu verstärkenden Signales führt.

Der Erfindung liegt daher die Aufgabe zugrunde, einen gattungsgemäßen Schaltverstärker für hohe Puls-Ausgangsleistungen und geringer Verzerrung des NF-Signales anzugeben.

Diese Aufgabe wird erfindungsgemäß durch die im Kennzeichen des Anspruchs 1 angegebenen Merkmale gelöst. Weiterbildungen sind in den Unteransprüchen angegeben.

In der erfindungsgemäßen Schaltung werden dem Ausgangstransformator an beiden Wicklungsenden in vorteilhafter Weise annährend konstante symmetrische Rechtecksignale angeboten. Die PDM-Modulation des Ausgangssignales entsteht durch eine Phasenverschiebung zwischen den beiden Rechtecksignalen, die mit dem Pegel des Eingangssignales korrespondiert. Die Phasenverschiebung wird in der erfindungsgemäßen Schaltung in vorteilhafter Weise bei der PDM-Modulation durch Invertierung des Komparatorsignals gewonnen. Die Verstärkung von symmetrischen Rechtecksignalen bietet den Vorteil, daß Verzerrungen, die beim Schalten von nadelförmigen PDM-Pulsen entstehen, vermieden werden.

In den Unteransprüchen ist weiterhin auf den Vorteil hingewiesen, daß für die erfindungsgemäße Lösung ein eisenloser Ausgangstransformator einsetzbar ist und daß dessen Streuinduktivität als ein Teil der Eingangsinduktivität des Tiefpaßfilters ausgenutzt werden kann.

Die Erfindung wird im folgenden anhand von Ausführungsbeispielen näher erläutert unter Bezugnahme auf eine schematische Zeichnung. Es zeigen

Fig. 1     ein Ausführungsbeispiel

Fig. 3     ein Diagramm zur Erläuterung der Funktionsweise
           des Ausführungsbeispiels

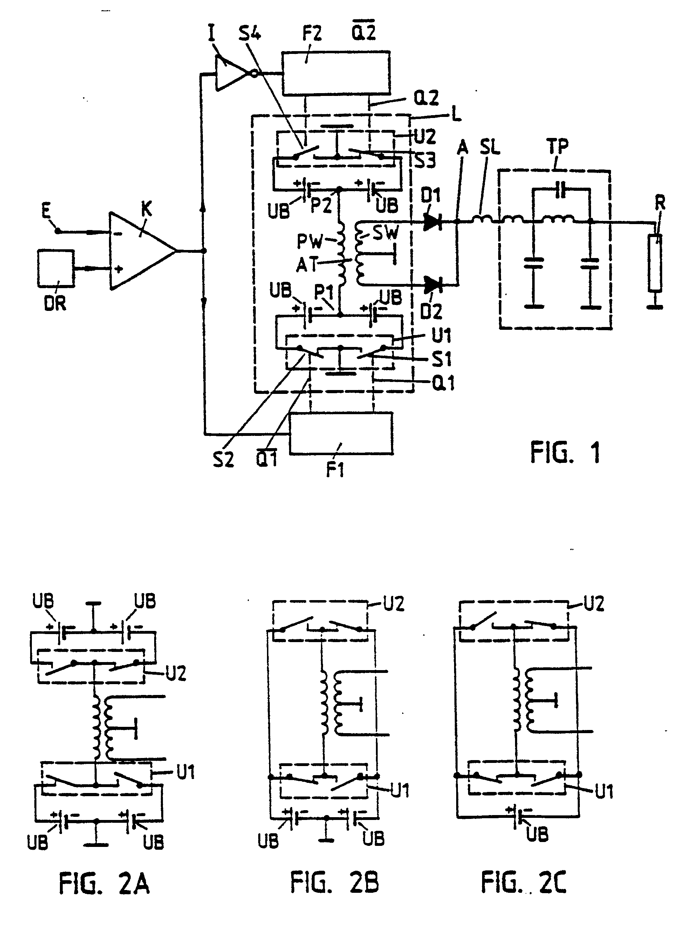

Fig. 2a    Ausgestaltungen und/oder Weiterbildungen
bis 2c     von
und 4a-d   Teilbereichen des Ausführungsbeispiels.

Fig. 1 zeigt einen beispielhaften Schaltverstärker, an dessen Eingang E ein zu verstärkendes NF-Signal anliegt. Dieses hat z. B. eine Bandbreite von 7,5 kHz sowie einen beispielhaften maximalen Spitze-Spitze-Wert der Amplitude von 1 Volt. Der Ausgang A, in welchem das entsprechende PDM-Signal anliegt, ist an den Eingang eines Tiefpaßfilters TP angeschlossen, das z. B. ein sogenanntes Pi-Glied ist und im wesentlichen aus Kapazitäten sowie Induktivitäten besteht. Das Tiefpaßfilter TP hat eine besonders hohe Sperrdämpfung von z. B. ungefähr 70 dB für die sich ergebende Pulswiederholfrequenz von ungefähr 52 kHz. Am Ausgang des Tiefpaßfilters TP ist eine Last R angeschlossen, z. B. die eingangs erwähnte Endstufe zur Trägermodulation.

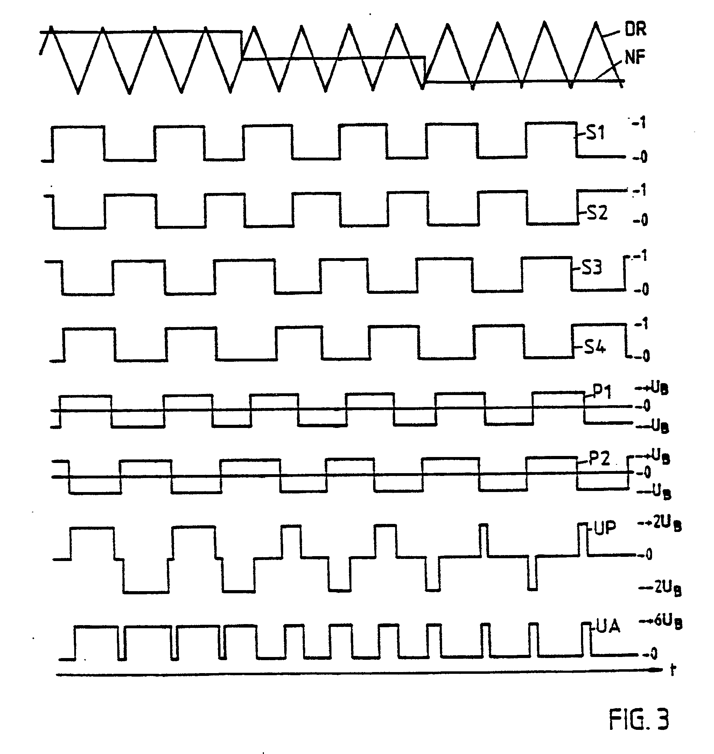

Das am Eingang E liegende NF-Signal gelangt auf einen Eingang -, z.B. den invertierenden Eingang, eines Komparators K, an dessen anderem Eingang + ein sogenanntes-Dreieckssignal anliegt. Dieses wird von einem Dreieckgenerator DR erzeugt, besitzt eine Grundfrequenz von 52,5 kHz und eine Amplitude die größer ist als diejenige des NF-Signales. Dieses wird nachfolgend anhand der Fig. 3 näher erläutert.

Am Ausgang des Komparators K entsteht ein entsprechend frequenz- und/oder phasenmoduliertes Rechtecksignal mit einer Grundfrequenz, die im wesentlichen ebenfalls 52,5 kHz beträgt. Dieses Rechtecksignal wird dem Eingang eines flankengetriggerten ersten Flip-Flop-Bauelementes F1 (D-Flip-Flop) direkt zugeführt, während an dem Eingang eines flankengetriggerten zweiten Flip-Flop-Bauelemtes F2 ein durch einen Inverter I invertiertes Rechtecksignal anliegt. Alternativ dazu ist es auch möglich, einen Komparator K mit komplementären Ausgängen zu benutzen. In diesem Falle kann auf den Inverter I verzichtet werden. Die Flip-Flop-Bauelemente F1, F2 werden jeweils mit der ansteigenden Flanke des anliegenden Rechtecksignales umgeschaltet. Die Flip-Flop-Bauelemente F1 bzw. F2 besitzen komplementäre Ausgänge Q1, $\overline{Q1}$ bzw. Q2, $\overline{Q2}$. Diese steuern eine Leistungsbrücke L an. Diese enthält einen Ausgangstransformator AT mit einer Sekundärwicklung SW, deren Windungszahl beispielsweise dreimal größer ist als diejenige der Primärwicklung PW.

An die Sekundärwicklung SW, mit auf Masse (Erdpotential) gelegter Mittelanzapfung ist ein Doppelweggleichrichter angeschlossen, der aus den Gleichrichterdioden D1, D2 besteht. Der Ausgang des Gleichrichters bildet den Ausgang A des Schaltverstärkers.

Zwischen der Sekundärwicklung SW und dem Ausgang A sind also keine schaltenden Bauelemente, z.B. Transistoren, vorhanden. Die Primärwicklung PW wird von einem geschalteten Gleichstrom durchflossen, dessen Richtung umgeschaltet wird. Dazu sind die Anschlüsse P1, P2 der Primärwicklung PW jeweils mit dem Mittelpunkt einer Reihenschaltung zweier Gleichspannungsquellen UB verbunden, von denen jede einzelne z.B. eine Spannung von 5 kV erzeugt. An die Enden der Reihenschaltung sind Umschalter U1 bzw. U2 angeschlossen, die ebenfalls aus jeweils einer Reihenschaltung von jeweils zwei Halbleiter-Schaltern S1, S2 bzw. S3, S4 bestehen. Die Verbindungspunkte von S1 mit S2 bzw. S3 mit S4 sind mit Masse verbunden, z.B. einer gesonderten Masseleitung. Die Halbleiter-Schalter S1, S2 bzw. S3, S4 werden von den Ausgängen Q1, $\overline{Q1}$ bzw. Q2, $\overline{Q2}$ der zugehörigen Flip-Flop-Bauelemente F1 bzw. F2 angesteuert. In den Fig. 2a bis 2c sind alternative Ausführungsbeispiele der Leistungsbrücke L dargestellt.

Fig. 3 zeigt zur Erläuterung des beschriebenen Ausführungsbeispiels von der Zeit t abhängige schematische Diagramme. Das mit NF bezeichnete Eingangssignal hat einen beispielhaften treppenförmigen Spannungsverlauf, welcher den Amplitudenwerten Oberstrich, Träger (Mittelstrich) sowie Unterstrich entspricht. Das Dreiecksignal DR besitzt eine Grundfrequenz von z.B. 52,5 kHz und eine maximale Amplitude (Spitze-Spitze-Wert) die größer ist als die Differenz zwischen Ober- und Unterstrich. An den Kreuzungspunkten zwischen NF- und Dreiecksignal schaltet der Komparator K, es entsteht ein nicht dargestelltes Rechtecksignal mit einer Grundfrequenz von ebenfalls 52,5 kHz. Dieses bewirkt ein Öffnen sowie Schließen der Schalter S1 bis S4 gemäß den mit S1 bis S4 bezeichneten Kurven mit einer Schaltfrequenz, die im wesentlichen 26,25 kHz beträgt. Dabei bedeutet "1" einen geschlossenen und "0" einen offenen Schalter. An den Anschlüssen P1, P2 der Primärwicklung PW entstehen dadurch entsprechende Spannungssprünge von +UB auf -UB oder umgekehrt, bezüglich des Massepotentials von 0 Volt. Wird nun die Spannungsdifferenz zwischen den Anschlüssen P1 und P2 gemessen, so ergibt sich der an der Primärwicklung PW anliegende Spannungsverlauf UP bezüglich des Massepotentials von 0 Volt. Aus dem Spannungsverlauf UP ist ersichtlich, daß die Halbleiter-Schalter S1 bis S4 so angesteuert werden, daß bei einem beispielhaften Spannungssprung von +2UB auf -2UB (erfolgt bei dem NF-Signal "Oberstrich") immer zunächst für eine geringe Zeit auf Massepotential geschaltet wird. Dieses erfolgt als Vorsichtsmaßnahme gegen ein ansonsten vorhandenes störendes Kurzschließen zweier Spannungsquellen UB. Ein derartiger Kurzschluß wird in der dargestellten Weise dadurch verhindert, daß das Dreieckssignal eine größere maximale Amplitude besitzt als der Wert "Oberstrich" des NF-Signals. Durch diese Maßnahme wird auch verhindert, daß bei dem Wert "Unterstrich" keine Pulse entstehen.

Aus dem Spannungsverlauf UP, einer beispielhaften 1:3-Aufwärtstransformation sowie anschließender Doppelweg Gleichrichtung entsteht am Ausgang A das gewünschte PDM-Signal mit Pulsen, deren Pulshöhe 6UB beträgt, also 30 kV bei Spannungsquellen UB von je 5kV und einer doppelt so hohen Frequenz wie die Ansteuerfrequenz der jeweiligen Halbbrücken S1/S2 bzs. S3/S4. Daraus wird ersichtlich, daß die Halbleiter-Schalter S1 bis S4 bei niedrigen Spannungen schalten.

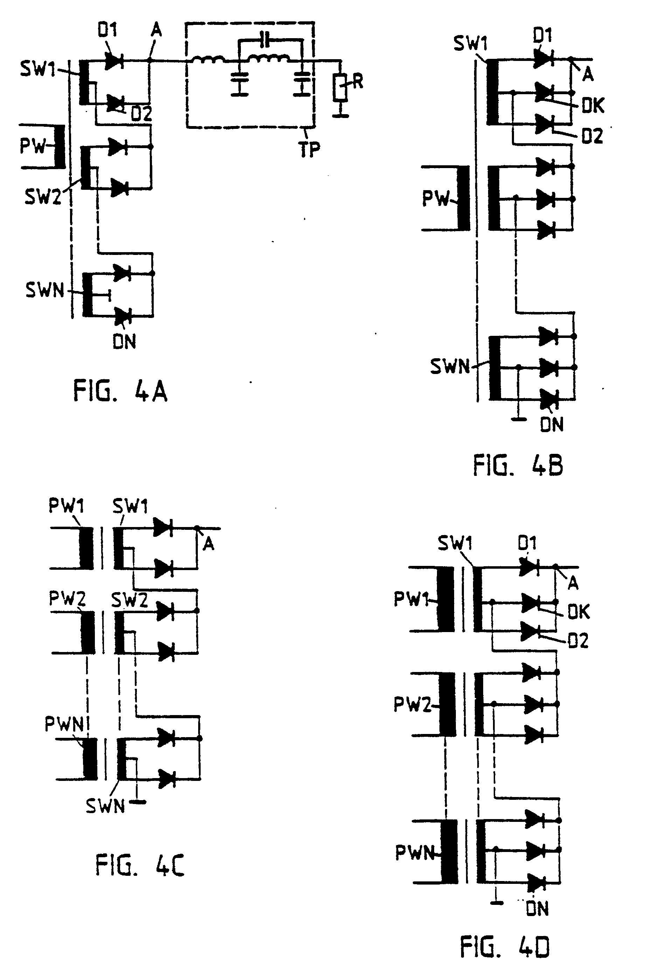

Fig. 4a-d zeigt vier alternativ verwendbare Schaltungen von verwendbaren Ausgangstransformatoren AT mit einer Primärwicklung PW oder mehreren Primärwicklungen bzw. Übertragern und mehreren galvanisch voneinander getrennten Sekundärwicklungen SW. An jede Sekundärwicklung SW1 bis SWN ist ein Doppelweggleichrichter D1 bis DN, z.B. jeweils zwei Gleichrichterdioden, angeschlossen. Die entstehenden Einzelgleichspannungen werden durch Reihenschaltung addiert, ein Ende liegt auf Massepotential, während das andere Ende den Ausgang A des Schaltverstärkers bildet. Die Dioden DK dienen zur Überbrückung der Unsymmetrie wie auch der Strominduktivität der Übertrager.

Bei einem derartigen Schaltverstärker ist es besonders zweckmäßig, die Halbleiterschalter S1 bis S4 so anzusteuern, daß diese im wesentlichen gleichlange Einschaltdauern besitzen, die vorzugsweise im wesentlichen der halben Periodendauer des Rechtecksignales entsprechen, das die Umschalter U1, U2 ansteuert. Dieses ist durch ein symmetrisch ausgebildetes Dreieckssignal DR (Fig. 3) erreichbar.

Aus Fig. 3, Kurven S1 bis S4, geht außerdem hervor, daß sich vorteilhafterweise die Einschaltdauer der Halbleiterschalter in Abhängigkeit von der erzeugten Pulsbreite (Kurve UA) lediglich in vernachlässigbarer Weise ändert.

Die Erfindung ist nicht auf die beschriebenen Beispiele beschränkt, sondern sinngemäß auf weitere anwendbar. Beispielsweise sind als Halbleiter-Schalter sogenannte GTO (gate-turn-off)-Thyristoren und/oder Kombinationen von mehreren Transistoren, z.B. Leistungsfeldeffektransistoren, verwendbar.

**Patentansprüche**

1. Schaltverstärker, insbesondere zur Erzeugung eines verstärkten NF-Signals für eine amplitudenmodulierte Anodenspannung eines Hochfrequenz-Leistungssenders, bei welchem an einem elektrischen Ausgang ein dem NF-Signal entsprechendes pulsdauermoduliertes Ausgangssignal vorhanden ist und der einen Ausgangstransformator mit mindestens einer Sekundärwicklung enthält, die schalterfrei mit dem Ausgang des Verstärkers verbunden ist, dadurch gekennzeichnet, daß die elektrischen Anschlüsse der Primärwicklung (PW) des Ausgangstransformators (AT) mit einer Schaltungsanordnung, bestehend aus jeweils einem elektrischen Umschalter (U1, U2) sowie mindestens einer elektrischen Gleichspannungsquelle (UB), derart verbunden sind, daß ein durch die Primärwicklung (PW) sowie die Umschalter (U1, U2) fließender Strom in entgegengesetzte Richtungen umschaltbar ist, daß jeweils ein Umschalter (U1) eine Reihenschaltung aus mindestens zwei Halbleiterschaltern (S1, S2) enthält und daß eine Steuerschaltung vorhanden ist, die jedem der Halbleiterschalter (S1, S2, S3, S4) der Umschalter (U1, U2) jeweils ein Rechtecksignal zuführt, das bei einer Verstärkung von NF-Signalen ein konstantes Puls-/Pausenverhältnis von 1:1 aufweist, wobei jeweils die zwei Steuersignale eines Umschalters (U1 bzw. U2) komplementär zueinander sind und daß zwischen den Rechtecksignalen (P1, P2) an den Ausgängen der Umschalter (U1, U2) eine Phasenverschiebung vorhanden ist, die von dem zu verstärkenden Eingangssignal abhängt.

2. Schaltverstärker nach Anspruch 1, dadurch gekennzeichnet, daß in der Steuerschaltung jedem Umschalter (U1) ein flankengetriggertes Flip-Flop-Bauelement (F1) zugeordnet ist, dessen komplementär arbeitende Ausgänge (Q1, $\overline{Q1}$) jeweils einen Halbleiterschalter (S1, S2) des Umschalters (U1) ansteuern.

3. Schaltverstärker nach Anspruch 1 oder Anspruch 2, dadurch gekennzeichnet, daß die Steuerschaltung einen Komparator (K) enthält, an dessen einem Eingang (-) das zu verstärkende Eingangssignal anliegt, an dessen anderem Eingang (-) ein Dreiecksignal anliegt, dessen Wiederholfrequenz wesentlich größer ist als die höchste Frequenz des Eingangssignals und das von einem Dreiecksgenerator (DR) erzeugt wird, und an dessen Ausgang ein von dem Eingangssignal und dem Dreieckssignal abhängiges Rechtecksignal entsteht, das den Flip-Flop-Bauelementen (F1, F2) zugeführt wird.

4. Schaltverstärker nach einem der vorhergehenden Ansprüche, dadurch gekennzeichnet, daß der Komparator (K) und/oder die Flip-Flop-Bauelemente ·(F1, F2) derart ausgebildet sind, daß die Flip-Flop-Bauelemente (F1, F2) bei entgegengesetzten Flankensteigungen des Rechtecksignales triggerbar sind.

5. Schaltverstärker nach einem der vorhergehenden Ansprüche, dadurch gekennzeichnet, daß bei der Sekundärwicklung (SW) eine wesentlich größere Gesamtwindungszahl möglich ist als bei der Primärwicklung (PW).

6. Schaltverstärker nach einem der vorhergehenden Ansprüche, dadurch gekennzeichnet, daß die Sekundärwicklung (SW) mit mindestens einem Halbleiter-Gleichrichter (D1, D2) verbunden ist, der mit dem Ausgang (A) verbunden ist, an den ein Tiefpaßfilter (TP) angekoppelt ist, dessen Ausgang mit einer Last (R) verbunden ist.

7. Schaltverstärker nach einem der vorhergehenden Ansprüche, dadurch gekennzeichnet, daß der Ausgangstransformator mindestens zwei galvanisch getrennte Sekundärwicklungen besitzt, die jeweils mit mindestens einem Halbleiter-Gleichrichter verbunden sind, daß die durch die Halbleiter-Gleichrichter erzeugten Gleichspannungen durch Reihenschaltung addiert werden und daß der Ausgang der Reihenschaltung mit dem Eingang eines nachgeschalteten Tiefpaßfilters verbunden ist, dessen Ausgang mit einer Last verbunden ist (Fig. 4a-d).

8. Schaltverstärker nach einem der vorhergehenden Ansprüche, dadurch gekennzeichnet, daß der Ausgangstransformator eisenlos ist und daß eine dann auftretende Streuinduktivität (SL) als ein Teil der Eingangsinduktivität des Tiefpaßfilters (TP) verwendbar ist.

9. Schaltverstärker nach einem der vorhergehenden Ansprüche, dadurch gekennzeichnet, daß anstatt des Ausgangstransformators mehrere Einzelnetzgeräte vorhanden sind, deren Primärwicklungen parallel geschlossen sind und/oder durch jeweils zugehörige Umschalter geschaltet werden (Fig. 4c, d).

**Claims**

1. Switching amplifier, in particular for the production of an amplified low-frequency signal for an amplitude-modulated anode voltage of a high-frequency power transmitter, in which a pulse-width-modulatedoutput signal corresponding to the low-frequency signal is present at an electrical output and which contains an output transformer with at least one secondary winding which is connected·without switches with the output of the amplifier, characterised thereby, that the electrical terminals of the primary winding (PW) of the output transformer (AT) are connected with a circuit arrangement, which consists each time of an electrical change-over switch (U1, U2) as well as of at least one electrical direct voltage source (UB) in such a manner that a current flowing through the primary winding (PW) as well as the change-over switches (U1, U2) is switchable over into opposite directions, that one change-over switch (U1) each time contains a series connection of at least two semiconductor switches (S1, S2) and that a control circuit is present, which feeds a respective rectangular signal, which for an amplification of low-frequency signals displays a constant pulse-to-pause ratio of 1:1, to each of the semiconductor switches (S1, S2, S3, S4) of the change-over switches (U1, U2), wherein the two control signals of a change-over switch (U1 or U2) are each complementary to the other and that a phase-displacement, which is dependent on the input signal to be amplified, is present between the rectangular signals (P1, P2) at the outputs of the change-over switches (U1, U2).

2. Switching amplifier according to claim 1, characterised thereby, that an edge-triggered flip-flop component (F1), the complementarily operating outputs (Q1, $\overline{Q1}$) of which each drive a respective semiconductor switch (S1, S2) of the change-over switch (U1), is associated with each change-over switch (U1) in the control circuit.

3. Switching amplifier according to claim 1 or claim 2, characterised thereby, that the control circuit contains a comparator (K), at the one input (-) of which the input signal to be amplified is present and at the other input (+) of which a triangular signal is applied, the repetition frequency of which is substantially higher than the highest frequency of the input signal and which is generated by a triangle generator (DR) and at the output of which arises a rectangular signal which is dependent on the input signal and the triangular signal and which is fed to the flip-flop components (F1, F2).

4. Switching amplifier according to one of the preceding claims, characterised thereby, that the comparator (K) and/or the flip-flop components (F1, F2) are constructed in such a manner that the flip-flop components (F1, F2) are triggerable for oppositely rising edges of the rectangular signal.

5. Switching amplifier according to one of the preceding claims, characterised thereby, that a substantially greater number of turns is possible for the secondary winding (SW) than for the primary winding (PW).

6. Switching amplifier according to one of the preceding claims, characterised thereby, that the secondary winding (SW) is connected with at least one semiconductor rectifier (D1, D2), which is connected with the output (A), to which a low-pass filter (TP) is coupled, the output of which is connected with a load (R).

7. Switching amplifier according to one of the preceding claims, characterised thereby, that the output transformer comprises at least two conductively separate secondary windings which are each respectively connected with at least one semiconductor rectifier, that the direct voltages produced by the semiconductor rectifiers are added by series connection and that the output of the series connection is connected with the input of a low-pass filter, which is connected therebehind and the output of which is connected with a load (Figures 4a to 4d).

8. Switching amplifier according to one of the preceding claims, characterised thereby, that the output transformer has an air core and that a stray inductance (SL) then arising is usable as part of the input inductance of the low-pass filter (TP).

9. Switching amplifier according to one of the preceding claims, characterised thereby, that several individual mains units, the primary windings of which are connected in parallel and/or are switched by respectively associated change-over switches, are present instead of the output transformer (Figures 4c and 4d).

## Revendications

1. Amplificateur à commutation, servant en particulier à générer un signal BF amplifié pour une tension d'anode modulée en amplitude d'un émetteur haute fréquence de grande puissance, amplificateur dont une sortie électrique présente un signal de sortie modulé en conformité avec le signal BF par une modulation d'impulsions en durée, et qui contient un transformateur de sortie avec au moins un enroulement secondaire relié à la sortie de l'amplificateur sans interposition d'un interrupteur, caractérisé en ce que les bornes électriques de l'enroulement primaire (PW) du transformateur de sortie (AT) sont reliées chacune à un montage constitué d'un commutateur électrique (U1, U2) et d'au moins une source de tension électrique continue (UB), de manière qu'un courant traversant l'enroulement primaire (PW) ainsi que les commutateurs (U1, U2) puisse être commuté pour circuler dans des sens contraires, que chaque commutateur (U1) contient un montage en série d'au moins deux interrupteurs à semi-conducteurs (S1, S2), que l'amplificateur comporte un circuit de pilotage appliquant à chacun des interrupteurs à semi-conducteurs (S1, S2, S3, S4) des commutateurs (U1, U2) un signal rectangulaire qui, lors d'une amplification de signaux BF, présente un rapport impulsion/intervalle entre impulsions constant de 1:1, les deux signaux de pilotage d'un commutateur (U1 ou U2) étant chaque fois complémentaires, et que les signaux rectangulaires (P1, P2) aux sorties des commutateurs (U1, U2) présentent un déphasage qui est fonction du signal d'entrée à amplifier.

2. Amplificateur à commutation selon la revendication 1, caractérisé en ce que le circuit de pilotage comporte, coordonné à chaque commutateur (U1), un composant, en forme de bascule (F1), déclenché par des flancs d'impulsion, dont les sorties (Q1, $\overline{Q1}$), agissant de façon complémentaire, pilotent chacune un interrupteur à semi-conducteur (S1, S2) du commutateur (U1).

3. Amplificateur à commutation selon la revendication 1 ou 2, caractérisé en ce que le circuit de pilotage contient un comparateur (K), à l'une (-) des entrées duquel est appliqué le signal d'entrée à amplifier, à l'autre entrée (+) duquel est appliqué un signal triangulaire dont la fréquence de récurrence est nettement supérieure à la fréquence la plus haute du signal d'entrée et qui est généré par un générateur de signaux triangulaires (DR), et à la sortie duquel est produit un signal rectangulaire dépendant du signal d'entrée et du signal triangulaire et qui est appliqué aux bascules (F1, F2).

4. Amplificateur à commutation selon une des revendications précédentes, caractérisé en ce que le comparateur (K) et/ou les bascules (F1, F2) sont réalisés de manière que les bascules (F1, F2) puissent être déclenchées par des flancs à sens de croissance contraires du signal rectangulaire.

5. Amplificateur à commutation selon une des revendications précédentes, caractérisé en ce que l'enroulement secondaire (SW) peut comporter un nombre total de spires beaucoup plus grand que l'enroulement primaire (PW).

6. Amplificateur à commutation selon une des revendications précédentes, caractérisé en ce que l'enroulement secondaire (SW) est raccordé à au moins un redresseur à semi-conducteurs (D1, D2) relié à la sortie (A), à laquelle est couplé un filtre passe-bas (TP) dont la sortie est connectée à une charge (R).

7. Amplificateur à commutation selon une des revendications précédentes, caractérisé en ce que le transformateur de sortie possède au moins deux enroulements secondaires isolés galvaniquement et raccordés chacun à au moins un redresseur à semi-conducteurs, que les tensions continues fournies par les redresseurs à semi-conducteurs sont additionnées par un montage en série et que la sortie du montage en série est reliée à l'entrée d'un filtre passe-bas prévu à la suite et dont la sortie est connectée à une charge (Fig. 4a-d).

8. Amplificateur à commutation selon une des revendications précédentes, caractérisé en ce que le transformateur de sortie est sans fer et que l'inductance de fuite (SL) apparaissant en raison de l'absence de fer, est utilisable comme une partie de l'inductance d'entrée du filtre passe-bas (TP).

9. Amplificateur à commutation selon une des revendications précédentes, caractérisé en ce qu'il comporte, à la place du transformateur de sortie, plusieurs appareils individuels d'alimentation à partir du secteur, dont les enroulement primaires sont connectés en parallèle et/ou sont commutés par des commutateurs associés (Fig. 4c, d).

FIG. 1

FIG. 2A

FIG. 2B

FIG. 2C

FIG. 3

FIG. 4A

FIG. 4B

FIG. 4C

FIG. 4D